# EUROPEAN PATENT APPLICATION

(11) **EP 4 465 365 A1**
(43) Date of publication of application: **20.11.2024**
(21) Application number: 23173896.4
(22) Date of filing: 17.05.2023
(51) Int. Cl.: H01L 29/78, H01L 29/06, H01L 21/336

(54) **VERTICAL POWER SEMICONDUCTOR DEVICE**

(71) Applicant: Infineon Technologies Austria AG, 9500 Villach (AT)
(72) Inventor: SHIM, Heejae, 9020 Klagenfurt am Wörthersee (AT); SIEMIENIEC, Ralf, 9500 Villach (AT); BHANDARI, Jyotshna, 9500 Villach (AT)
(74) Representative: Müller Hoffmann & Partner

(57) **Abstract**

A vertical power semiconductor device (100) is proposed. The vertical power semiconductor device (100) includes a silicon carbide, SiC, semiconductor body (102) including an active area (103) and an edge termination area (104) at least partly surrounding the active area (103). The vertical power semiconductor device (100) further includes a plurality of trench device cells (TC) in the active area (103). Each of the plurality of trench device cells (TC) includes at least one trench structure (106) and a drift region (108) of a first conductivity type. The vertical power semiconductor device (100) further includes an edge termination structure (110) in the edge termination area (104). A transition area (112) is arranged between the active area (103) and the edge termination area (104) along a first lateral direction (x1). The transition area (112) includes an edge trench structure (114) having a larger volume fraction of dielectric material than the at least one trench structure (106).

## Description

### TECHNICAL FIELD

The present disclosure is related to a vertical power semiconductor device, in particular to a vertical power semiconductor device comprising an edge termination area in a semiconductor body.

### BACKGROUND

In vertical power semiconductor devices, a load current flows between a first load electrode on the front side and a second load electrode on the rear side of the semiconductor device. In the off state, the reverse voltage is dropped in a vertical direction between the first and second load electrodes and in a lateral direction across an edge termination area between a central, active region of the semiconductor device and a structure formed along the lateral side surface of the semiconductor body with the electrical potential of the second load electrode. For the lateral field reduction, vertical power semiconductor devices include termination structures such as JTE (Junction Termination Extension) regions, for example, the dopant concentration of which may decrease with decreasing distance from the side surface, or near-surface, floating and oppositely doped regions separated from one another (so-called guard rings). In semiconductor devices composed of semiconductor materials in which the diffusion coefficients of dopants are small, edge termination structures known from conventional silicon technology are less effective or more complicated to produce owing to the steeper pn junctions.

The present application is directed to a silicon carbide semiconductor device having an improved edge termination.

### SUMMARY

An example of the present disclosure relates to a vertical power semiconductor device. The vertical power semiconductor device comprises a silicon carbide, SiC, semiconductor body including an active area and an edge termination area at least partly surrounding the active area. The vertical power semiconductor device further includes a plurality of trench device cells in the active area. Each of the plurality of trench device cells includes at least one trench structure and a drift region of a first conductivity type. The vertical power semiconductor device further includes an edge termination structure in the edge termination area. The vertical power semiconductor device further includes a transition area arranged between the active area and the edge termination area along a first lateral direction. The transition area includes an edge trench structure having a larger volume fraction of dielectric material than the at least one trench structure.

Another example of the present disclosure relates to a method of manufacturing a vertical power semiconductor device. The method includes forming a plurality of trench device cells in an active area of a silicon carbide, SiC semiconductor body. Each of the plurality of trench device cells includes at least one trench structure and a drift region of a first conductivity type. The method further includes forming an edge termination structure in an edge termination area at least partly surrounding the active area. The method further includes forming an edge trench structure in a transition area arranged between the active area and the edge termination area along a first lateral direction. The edge trench structure has a larger volume fraction of dielectric material than the at least one trench structure.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of vertical power semiconductor devices and together with the description serve to explain principles of the examples. Further examples are described in the following detailed description and the claims.
Fig. 1A is a top view for illustrating an example of a vertical power semiconductor device including an edge trench structure in a transition area between an active area and an edge termination area.
Fig. 1B is an exemplary cross-sectional view along line AA' of Fig. 1A.
Fig. 2 is an exemplary cross-sectional view for illustrating a trench device cell according to a configuration example of a vertical power semiconductor device.
Fig. 3 is an exemplary cross-sectional view for illustrating another example of a vertical power semiconductor device including an edge trench structure in a transition area between an active area and an edge termination area.
Fig. 4 is an exemplary cross-sectional view for illustrating an edge termination structure in an edge termination area according to a configuration example of a vertical power semiconductor device.

### DETAILED DESCRIPTION

In the following detailed description, reference is made to the accompanying drawings, which form a part hereof and in which are shown by way of illustrations specific examples of vertical power semiconductor devices. It is to be understood that other examples may be utilized and structural or logical changes may be made without departing from the scope of the present disclosure. For example, features illustrated or described for one example can be used in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" may describe a permanent low-resistive connection between electrically connected elements, for example a direct contact between the concerned elements or a low-resistive connection via a metal and/or heavily doped semiconductor material. The term "electrically coupled" may include that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact may be a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example of the present disclosure relates to a vertical power semiconductor device. The vertical power semiconductor device includes a silicon carbide, SiC, semiconductor body including an active area. An edge termination area may at least partly, e.g. entirely, surround the active area. The vertical power semiconductor device may further include a plurality of trench device cells in the active area. Each of the plurality of trench device cells may include at least one trench structure and a drift region of a first conductivity type. The vertical power semiconductor device may further include an edge termination structure in the edge termination area. The vertical power semiconductor device may further include a transition area arranged between the active area and the edge termination area along a first lateral direction. The transition area may include an edge trench structure having a larger volume fraction of dielectric material than the at least one trench structure.

The vertical power semiconductor device may be part of or may be at least one of: an integrated circuit, a discrete semiconductor device, or a semiconductor module, for example.

The semiconductor device may be used in applications related to power transmission and distribution, automotive and transport, renewable energy, consumer electronics, and other industrial applications. The vertical power semiconductor device may be or a may include an insulated gate field effect transistor (IGFET) such as a metal oxide semiconductor field effect transistor (MOSFET), an insulated gate bipolar transistor (IGBT), or a junction field effect transistor (JFET), for example.

The vertical power semiconductor device may have a load current flow between a first surface and a second surface opposite to the first surface. The first surface may be a front surface or a top surface of the semiconductor body, and the second surface may be a back surface or a rear surface of the semiconductor body, for example. The semiconductor body may be attached to a lead frame via the second surface, for example. Over the first surface of the semiconductor body, interconnects may be arranged on a contact pad structure of a wiring area for electrically connecting device elements in the semiconductor body to elements, e.g. other semiconductor devices, outside of the semiconductor device, for example. For example, a source or emitter contact may be part of the wiring area over the semiconductor body. The wiring area may include one or more than one, e.g. two, three, four or even more wiring levels. Each wiring level may be formed by a single one or a stack of conductive layers, e.g. metal layer(s). For example, the wiring levels may include at least one of Cu, Au, AlCu, Ag, or alloys thereof. The wiring levels may be lithographically patterned, for example. Between stacked wiring levels, an interlayer dielectric structure may be arranged. Contact plug(s) or contact line(s) may be formed in openings in the interlayer dielectric structure to electrically connect parts, e.g. metal lines or contact areas, of different wiring levels to one another. The source or emitter contact may be formed by one or more elements of the wiring area over the first surface. For example, the source or emitter contact may include a source or emitter pad that may be used as a bonding area. The source or emitter contact may also include further conductive structures e.g. contact plugs or lines, between the transistor cell area at the first surface and the source or emitter pad, for example. Likewise, the drain or collector contact may be formed by one or more elements of the wiring area over the second surface.

The vertical power semiconductor device may be configured to conduct currents of more than 1A, or more than 10 A, or more than 30 A, or more than 50A, or more than 75 A, or even more than 100A. The vertical power semiconductor device may be further configured to block voltages between load terminals, e.g. between collector and emitter of an IGBT, or between drain and source of a MOSFET or JFET, in the range of several hundreds of up to several thousands of volts, e.g. 400 V, 650V, 1.2kV, 1.7kV, 3.3kV, 4.5kV, 5.5kV, 6kV, 6.5kV, 10 kV.

The blocking voltage may correspond to a voltage class specified in a datasheet of the power semiconductor device, for example.

For example, the semiconductor body may comprise or may be an epitaxially deposited semiconductor material. Separately or in combination, the semiconductor body may comprise a growth substrate. For example, the vertical power semiconductor device may be based on a semiconductor body from a crystalline SiC material. For example, the semiconductor material may be 2H-SiC (SiC of the 2H polytype), 6H-SIC, 3C-SiC or 15R-SiC. According to an example, the semiconductor material is silicon carbide of the 4H polytype (4H-SiC). The semiconductor body may consist of a semiconductor substrate or may include or consist of a semiconductor substrate having none, one or more than one SiC layers, e.g. epitaxially grown SiC layers, thereon.

For realizing a desired current carrying capacity, the vertical power semiconductor device may be designed by a plurality of parallel-connected trench device cells, e.g. trench transistor cells, in a device cell area. The parallel-connected trench device cells may, for example, be trench transistor cells formed in the shape of a strip or a strip segment. The transistor cells can also have any other shape, e.g. circular, elliptical, polygonal such as hexagonal or octahedral. The trench device cells may be arranged in the device cell area, e.g. a transistor cell area, of the semiconductor body. The device cell area may be an active area where a source region of a FET or JFET at the first surface and a drain region of the FET or JFET are arranged opposite to one another along the vertical direction. Likewise, the transistor cell area may be an active area where an emitter region of an IGBT at the first surface and a collector region of the IGBT are arranged opposite to one another along the vertical direction. In the transistor cell area, a load current may enter or exit the semiconductor body of the FET, or JFET, or IGBT, e.g. via contact plugs on the first surface of the semiconductor body. For example, the transistor cell area may be defined by an area where source contact plugs or emitter contact plugs are placed over the first surface.

The blocking voltage of the vertical power semiconductor device may be adjusted by an impurity or doping concentration and/or a vertical extension of the drift region in the trench device cells. The drift region may be part of the SiC semiconductor body. A doping concentration of the drift region may gradually or in steps increase or decrease with increasing distance to the first surface at least in portions of its vertical extension. According to other examples, the impurity concentration in the drift region may be approximately uniform. A mean impurity concentration in the drift region may be between 5 × 10¹⁴ cm⁻³ and 1 × 10¹⁷ cm⁻³, for example in a range from 1 × 10¹⁵ cm⁻³ to 5 × 10¹⁶ cm⁻³. A vertical extent of the drift region may depend on voltage blocking requirements, e.g. a specified voltage class, of the device. When operating the vertical power semiconductor device in voltage blocking mode, a space charge region may vertically extend partly or totally through the drift region depending on the blocking voltage applied to the vertical power semiconductor device. When operating the vertical power semiconductor device at or close to the specified maximum blocking voltage, the space charge region may reach or penetrate into a buffer region that is configured to prevent the space charge region from further reaching to the second load electrode at the second surface. The buffer region may have a higher doping concentration than the drift region. The vertical profile of doping concentration in the buffer may enable an improvement of avalanche robustness and short circuit withstand capability. This may allow for improving reliability of the vertical power semiconductor device.

For example, the at least one trench structure may be stripe-shaped. The at least one trench structure may also have another layout or geometry in a plan view, e.g. hexagonal, square, circular, elliptic. Sidewalls of the trench structure may be non-tapered or slightly tapered, for example. In case of slightly tapered sidewalls of a trench gate structure including a gate electrode, a channel length may be slightly larger than the vertical extent of a channel region. The taper angle of the trench structure may be caused by process technology, e.g. aspect ratio of trench etch processes, and may also be used for maximizing the charge carrier mobility in the channel region which depends from the direction along which channel current flows. Another example for a tapered trench structure is a V-shaped trench structure.

The at least one trench structure may include one or more electrodes, e.g. a gate and/or field electrode. Each of the one or more electrodes may include a conductive material(s), e.g. metal, metal alloys, e.g. Cu, Au, AlCu, Ag, or alloys thereof, metal compounds, e.g. TiN, highly doped semiconductor material such as highly doped polycrystalline silicon, or allotropes of carbon, e.g. graphenic-like carbon. The one or more conductive materials may form a layer stack, for example. The at least one trench structure may further include one or more dielectric layers for electrically isolating the one or more electrodes from the surrounding SiC semiconductor body, for example. Exemplary materials for the one or more dielectric layers are, inter alia, oxides (e.g. silicate glass, deposited SiO₂, thermal SiO₂), nitrides (e.g., Si₃N₄), high-k dielectrics, low-k dielectrics, or any combination thereof.

The edge termination area may include a termination structure. In a blocking mode or in a reverse biased mode of a FET, or JFET, or IGBT, the blocking voltage between the transistor cell area and a field-free region laterally drops across the termination structure in the edge termination area. The termination structure may have a higher or a slightly lower voltage blocking capability than the transistor cell area. The termination structure may include a junction termination extension (JTE) with or without a variation of lateral doping (VLD), one or more laterally separated guard rings, or any combination thereof, for example. The wiring area may laterally adjoin to a passivation area that may be arranged over the edge termination area of a vertical power semiconductor device, for example.

Exemplary dielectric materials in the edge trench structure are, inter alia, oxides (e.g. silicate glass, deposited SiO₂, thermal SiO₂), nitrides (e.g., Si₃N₄), high-k dielectrics, low-k dielectrics, dielectric spacers, or any combination thereof. The larger volume fraction of dielectric material in the edge trench structure compared to the at least one trench structure may be caused by an edge trench structure cross-section that includes a larger area share of dielectric material than a cross-section of the at least one trench structure, the cross-sections being taken along the same lateral direction.

The edge trench structure in the transition area between the active area and the edge termination area may allow for mitigating the electric field profile with regard to the occurrence of critical field strengths from the active area toward the edge termination area. This may allow for improving the breakdown strength and reliability of the power semiconductor device. Moreover, the edge trench structure may relax/equalize the electric field that otherwise could locally increase to critical values in presence of rather sharp edges, e.g. caused by a difference in the pn junction depths of a shielding region and a shallower edge termination junction. The edge trench structure may be applied to any vertical power semiconductor devices in which in the active area, the doped region of the second conductivity type is deeper than the trench depth in order to reduce an electric field crowding of the trench structure in a blocking state.

For example, the edge trench structure may be a dielectric trench structure. In other words, an edge trench including the edge trench structure may be completely or entirely filled with dielectric material. For example, the dielectric trench structure may include at least two dielectric layers stacked on one another. For example, a thickness of a dielectric layer lining at least part of a sidewall and a bottom side of the edge trench structure may be larger than a thickness of a dielectric layer lining at least part of a sidewall and a bottom side of the at least one trench structure. In some examples, the dielectric layer completely lines sidewalls and bottom side portions of the edge trench structure. In some examples, the dielectric layer extends out of the edge trench structure on at least part of the first surface of the semiconductor body adjoining to the edge trench structure, for example. For example, the dielectric layer extending out of the edge trench structure may include a first part extending on the first surface of the semiconductor body along the first direction over at least part of the termination structure. A second part of the dielectric layer extending out of the edge trench structure may extend on the first surface of the semiconductor body along a direction opposite to the first direction over at least part of the active area. For example, an extent of the first part of the dielectric layer extending out of the edge trench structure may be larger than an extent of the second part of the dielectric layer extending out of the edge trench structure.

For example, the edge trench structure and the at least one trench structure may have at least one of i) matching widths along the first lateral direction, or ii) matching depths along a vertical direction. For example, an edge trench for the edge trench structure and a cell trench for the at least one trench structure may be formed by an etch process using an etch mask having same etch mask opening widths for the edge trench and the cell trench. In some other examples, an etch mask opening width for the edge trench may differ from, e.g. be larger or smaller, an etch mask opening width for the cell trench. A width and/or depth of the edge trench may be set for optimizing the blocking voltage behavior of the vertical power semiconductor device, for example.

For example, the at least one trench structure may be a gate trench structure. Each of the plurality of trench device structures may include a channel region adjoining to a first sidewall of the gate trench structure, and a diode region of a second conductivity type. The diode region may adjoin to a second sidewall and to a bottom side of the gate trench structure. The second sidewall may be being opposite to the first sidewall. A bottom portion of the diode region may be configured to protect the gate dielectric from high electric field strengths, for example.

For example, the diode region may include at least two sub-regions along the vertical direction. A vertical doping concentration profile of each of the at least two sub-regions may have a doping concentration peak. For example, a doping concentration peak of one or more of the at least two sub-regions may be located at a larger vertical distance to a reference level at a first surface of the semiconductor body than a bottom side of the gate trench structure. This may allow for an improved protection of the gate dielectric from high electric field strengths during a blocking mode operation of the vertical power semiconductor device, for example.

For example, a maximum depth of the diode region from a reference level at a first surface of the semiconductor body may be larger than a maximum depth of a center of an auxiliary region from the reference level. The auxiliary region may be of the second conductivity type and may adjoin to a bottom side of the edge trench structure. The maximum depth of the center of the auxiliary region from the reference level may be larger than a trench depth, e.g. the vertical distance from a bottom side of the edge trench structure to the reference level at the first surface. The auxiliary region of the second conductivity type may be covered by a bottom side of the edge trench structure. The auxiliary region, in combination with the edge trench structure including the dielectric material, may allow for shaping the electric field distribution in the edge termination area for improving electric breakdown strength. For example, the auxiliary region may be formed by ion implantation of dopants through a bottom side of the edge trench.

For example, the edge termination structure may include a first doped region of the second conductivity type between the first surface of the SiC semiconductor body and the drift region. The first doped region may at least partly surround the active region and may be spaced apart from the first surface. The edge termination structure may further include a plurality of second doped regions of the second conductivity type between the first surface and the first doped region. The edge termination structure may further include a third doped region of the first conductivity type separating adjacent second doped regions of the plurality of second doped regions from one another along the first lateral direction. The edge termination structure including the first, second, and third doped regions in combination with the edge trench structure including the dielectric material, may allow for shaping the electric field distribution in the edge termination area for improving electric breakdown strength.

For example, a dopant dose of the plurality of second doped regions may be larger than a dopant dose of the first doped region.

For example, the maximum depth of the center of the auxiliary region from the reference level may be larger than a maximum depth of the first doped region from the reference level.

Details with respect to structure, or function, or technical benefit of features described above with respect to a FET, or JFET, or IGBT likewise apply to the exemplary methods described herein. Processing the semiconductor body may comprise one or more optional additional features corresponding to one or more aspects mentioned in connection with the proposed concept or one or more examples described above or below.

It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, - processes, -operations or-steps, respectively. Such sub acts may be included and part of the disclosure of this single act unless explicitly excluded.

Another example of the present disclosure relates to a method of manufacturing a vertical power semiconductor device. The method may include forming a plurality of trench device cells in an active area of a silicon carbide, SiC, semiconductor body. Each of the plurality of trench device cells may include at least one trench structure and a drift region of a first conductivity type. The method may further include forming an edge termination structure in an edge termination area at least partly surrounding the active area. The method may further include forming an edge trench structure in a transition area arranged between the active area and the edge termination area along a first lateral direction. The edge trench structure may have a larger volume fraction of dielectric material than the at least one trench structure.

For example, forming the plurality of trench device cells may include forming a gate trench structure as the at least one trench structure. Forming the plurality of trench device cells may further include forming a channel region adjoining to a first sidewall of the gate trench structure. Forming the plurality of trench device cells may further include forming a diode region of a second conductivity type adjoining to a second sidewall and to a bottom side of the gate trench structure. The second sidewall is opposite to the first sidewall.

For example, the diode region may be formed by at least two sub-regions along a vertical direction. A vertical doping concentration profile of each of the at least two sub-regions may include a doping concentration peak. The at least two sub-regions may be formed by at least two ion implantation processes using a common ion implantation mask over a first surface of the SiC semiconductor body.

For example, forming the edge termination structure may include forming a first doped region of a second conductivity type between the first surface of the SiC semiconductor body and the drift region. The first doped region may at least partly surround the active region and may be spaced apart from the first surface. Forming the edge termination structure may further include forming a plurality of second doped regions of the second conductivity type between the first surface and the first doped region. Adjacent second doped regions of the plurality of second doped regions may be separated from one another along the first lateral direction by a third doped region of the first conductivity type. Lateral extents of the second doped region may vary, e.g. decrease, along the first lateral direction toward an edge of the power semiconductor device, for example.

The examples and features described above and below may be combined. Functional and structural details (e.g. materials, dimensions) described with respect to the examples above shall likewise apply to the examples illustrated in the figures and described further below.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

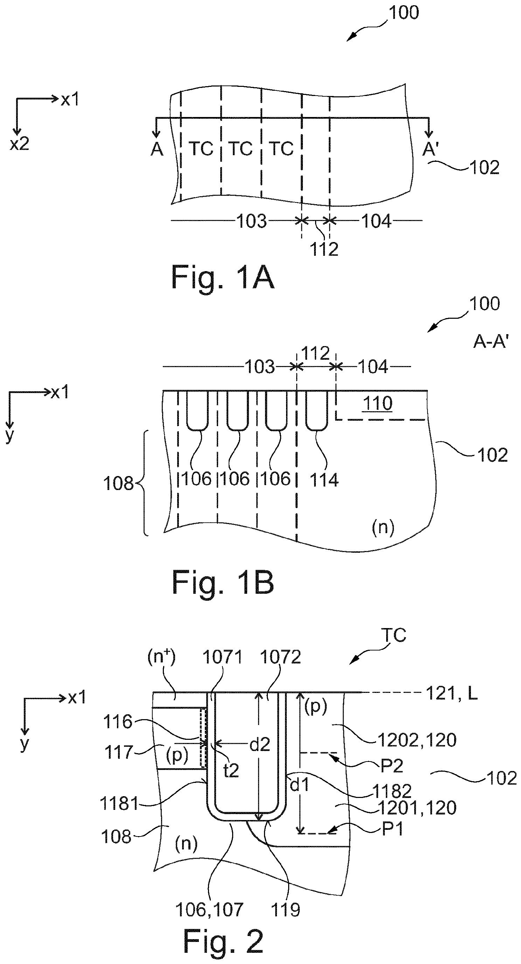

Fig. 1A schematically and exemplarily shows a partial top view of a vertical power semiconductor device 100. Fig. 1B schematically and exemplarily shows a partial cross-sectional view of the vertical power semiconductor device 100 of Fig. 1A along line AA'.

Referring to Figs. 1A and 1B, the vertical power semiconductor device 100 includes a SiC semiconductor body 102. The semiconductor body 102 include an active area 103 and an edge termination area 104. The edge termination area 104 at least partly surrounds the active area 103. The vertical power semiconductor device 100 further includes a plurality of trench device cells TC in the active area 103. Each of the plurality of trench device cells TC includes a trench structure 106 and an n-doped drift region 108. The vertical power semiconductor device 100 further includes an edge termination structure 110 in the edge termination area 104. In view of the variety of specific termination structure designs that may be included in the vertical power semiconductor device 100 illustrated in Figs. 1A, 1B, a portion of the edge termination structure 110 is illustrated in a simplified manner by a dashed line. A transition area 112 is arranged between the active area 103 and the edge termination area 104 along a first lateral direction x1. The transition area 112 includes an edge trench structure 114 having a larger volume fraction of dielectric material than the trench structures 106.

The specific structure of the trench device cells TCs depends on the type of vertical power semiconductor device, e.g. JFET, or MOSFET, or IGBT, and also depends on the specific layout chosen for the trench device cells TCs. The schematic illustration in Figs. 1A, 1B may include any of specific trench device cell layouts and is simplified in that the portion comprising the trench device cells TCs is denoted by a dashed line including the trench structure 106 in each of the trench device cells TCs.

The schematic cross-sectional view of Fig. 2 illustrates a configuration example of a trench device cell TC. The trench structure 106 is a gate trench structure 107 and includes a channel region 116 adjoining to a first sidewall 1181 of the gate trench structure 107. The gate trench structure 107 includes a gate electrode 1072 and a gate dielectric 1071 electrically separating the gate electrode 1072 from a surrounding part of the semiconductor body 102. The trench structure 106 may extend into the semiconductor body 102 from a first surface 121. The channel region 116 is part of a p-doped body region 117. A conductivity change in the channel region 116 may be controlled by field-effect via a change of the voltage change applied to the gate electrode 1072. For example, the channel region 116 may be an inversion channel in an on-state, e.g. electron channel in a p-doped body region. The trench device cell TC further includes a p-doped diode region 120 adjoining to a second sidewall 1182 and to a bottom side 119 of the gate trench structure 107. The second sidewall 1182 is opposite to the first sidewall 1181.

The diode region 120 includes two sub-regions 1201, 1202 along the vertical direction y. A vertical doping concentration profile of each of the two sub-regions 1201, 1202 includes a doping concentration peak P1, P2. A vertical position of the doping concentration peaks P1, P2 is indicated by a dashed line in Fig. 2. The two sub-regions 1201, 1202 may be formed by at least two ion implantation processes using a common ion implantation mask over the first surface of the SiC semiconductor body 102. In the configuration example of Fig. 2, the doping concentration peak P1 is located at a larger vertical distance d1 to a reference level L at the first surface 105 of the semiconductor body 102 than the bottom side 119 of the gate trench structure 107 having a vertical distance d2. The number of sub-regions illustrated in Fig. 2 merely represents a configuration example and the number may vary, e.g. be larger, in other configuration examples.

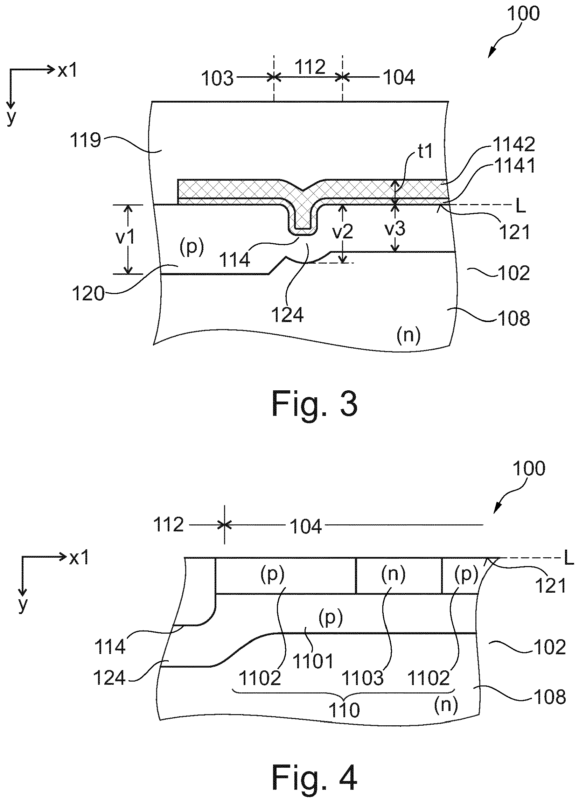

The schematic cross-sectional view of Fig. 3 illustrates a configuration of a vertical power semiconductor device. The edge trench structure 114 is a dielectric trench structure. In other words, the edge trench structure 114 is filled with dielectric material. The dielectric trench structure includes a first and a second dielectric layer 1141, 1142 stacked on one another. The dielectric layers 1141, 1142 extend out of the edge trench structure 114 and may extend on the first surface 121 of the SiC semiconductor body 102 in opposite directions, e.g. into the edge termination area 104 on one side and into the active area 103 on the opposite side. A lateral extent into the edge termination area 104 may be larger than a lateral extent into the active area 103, for example. A thickness t1 of the dielectric layer 1142 may be larger than a thickness t2 of the gate dielectric 1071 as illustrated in the configuration example of the trench device cell TC of Fig. 2.

A maximum depth v1 of the diode region 120 from the reference level L at the first surface 121 of the semiconductor body 102 is larger than a maximum depth v2 of a center of a p-doped auxiliary region 124 from the reference level L. The p-doped auxiliary region 124 adjoins to a bottom side of the edge trench structure 114. The maximum depth v2 is larger than a depth of the edge trench structure 114. The p-doped auxiliary region 124 is covered by a bottom side of the edge trench structure 114.

The schematic cross-sectional view of Fig. 4 illustrates a configuration example of an edge termination area 104 of a vertical power semiconductor device 100. The edge termination structure 110 includes a first p-doped region 1101 arranged between the first surface 121 of the SiC semiconductor body 102 and the n-doped drift region 108. The first p-doped region 1101 is spaced apart from the first surface 121. The edge termination structure 110 further includes a plurality of second p-doped regions 1102 arranged between the first surface 121 and the first p-doped region 1101. The edge termination structure 110 further includes a third n-doped region 1103 separating adjacent second p-doped regions 1102 from one another along the first lateral direction x1. The number of second p-doped regions 1102 and n-doped third regions 1103 may vary, e.g. depending on a lateral extent of the edge termination area 104, for example. For example, a dopant dose of the plurality of second p-doped regions 1102 may be set larger than a dopant dose of the first p-doped region 1101.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

The aspects and features mentioned and described together with one or more of the previously detailed examples and figures, may as well be combined with one or more of the other examples in order to replace a like feature of the other example or in order to additionally introduce the feature to the other example.

## Claims

1. A vertical power semiconductor device (100), comprising:
a silicon carbide, SiC semiconductor body (102) including an active area (103) and an edge termination area (104) at least partly surrounding the active area (103);
a plurality of trench device cells (TC) in the active area (103), wherein each of the plurality of trench device cells (TC) includes at least one trench structure (106) and a drift region (108) of a first conductivity type;
an edge termination structure (110) in the edge termination area (104);
a transition area (112) arranged between the active area (103) and the edge termination area (104) along a first lateral direction (x1), the transition area (112) comprising an edge trench structure (114) having a larger volume fraction of dielectric material than the at least one trench structure (106).

2. The vertical power semiconductor device (100) of the preceding claim, wherein the edge trench structure (114) is a dielectric trench structure.

3. The vertical power semiconductor device (100) of the preceding claim, wherein the dielectric trench structure includes at least two dielectric layers stacked on one another.

4. The vertical power semiconductor device (100) of claim 1, wherein a thickness (t1) of a dielectric layer lining at least part of a sidewall and a bottom side of the edge trench structure (114) is larger than a thickness (t2) of a dielectric layer lining at least part of a sidewall and a bottom side of the at least one trench structure (106).

5. The vertical power semiconductor device (100) of any one of the preceding claims, wherein the edge trench structure (114) and the at least one trench structure (106) have at least one of i) matching widths along the first lateral direction (x1), or ii) matching depths along a vertical direction (y).

6. The vertical power semiconductor device (100) of any one of the preceding claims, wherein the at least one trench structure (106) is a gate trench structure (107), each of the plurality of trench device structures (TC) including a channel region (116) adjoining to a first sidewall (1181) of the gate trench structure (107), and a diode region (120) of a second conductivity type adjoining to a second sidewall (1182) and to a bottom side (119) of the gate trench structure (107), the second sidewall (1182) being opposite to the first sidewall (1181).

7. The vertical power semiconductor device (100) of the preceding claim, wherein the diode region (120) includes at least two sub-regions along the vertical direction (y), wherein a vertical doping concentration profile of each of the at least two sub-regions includes a doping concentration peak.

8. The vertical power semiconductor device (100) of any one of the preceding claims, wherein a maximum depth (v1) of the diode region (116) from a reference level (L) at a first surface (121) of the semiconductor body (102) is larger than a maximum depth (v2) of a center of an auxiliary region (124) from the reference level (L), the auxiliary region (124) being of the second conductivity type and adjoining to a bottom side of the edge trench structure (114).

9. The vertical power semiconductor device (100) of any one of the preceding claims, wherein the edge termination structure (110) includes
a first doped region (1101) of the second conductivity type between the first surface (121) of the SiC semiconductor body (102) and the drift region (108), the first doped region (1101) at least partly surrounding the active region (103) and being spaced apart from the first surface (121);
a plurality of second doped regions (1102) of the second conductivity type between the first surface (121) and the first doped region (1101); and
a third doped region (1103) of the first conductivity type separating adjacent second doped regions of the plurality of second doped regions (1102) from one another along the first lateral direction (x1).

10. The vertical power semiconductor device (100) of the preceding claim, wherein a dopant dose of the plurality of second doped regions (1102) is larger than a dopant dose of the first doped region (1101).

11. The vertical power semiconductor device (100) of any of the preceding claims, wherein the maximum depth (v2) of the center of the auxiliary region (124) from the reference level (L) is larger than a maximum depth (v3) of the first doped region (1101) from the reference level (L).

12. A method of manufacturing a vertical power semiconductor device (100), the method comprising:
forming a plurality of trench device cells (TC) in an active area (103) of a silicon carbide, SiC semiconductor body (102), wherein each of the plurality of trench device cells (TC) includes at least one trench structure (106) and a drift region (108) of a first conductivity type;
forming an edge termination structure (110) in an edge termination area (104) at least partly surrounding the active area (103); and
forming an edge trench structure (114) in a transition area (112) arranged between the active area (103) and the edge termination area (104) along a first lateral direction (x1), the edge trench structure (114) having a larger volume fraction of dielectric material than the at least one trench structure (106).

13. The method of the preceding claim, wherein forming the plurality of trench device cells (TC) includes:
forming a gate trench structure (107) as the at least one trench structure (106);
forming a channel region (116) adjoining to a first sidewall (1181) of the gate trench structure (107);
forming a diode region (120) of a second conductivity type adjoining to a second sidewall (1182) and to a bottom side (119) of the gate trench structure (107), the second sidewall (1182) being opposite to the first sidewall (1181).

14. The method of any one of the two preceding claims, wherein the diode region (120) is formed by at least two sub-regions along a vertical direction (y), and a vertical doping concentration profile of each of the at least two sub-regions includes a doping concentration peak, the at least two sub-regions being formed by at least two ion implantation processes using a common ion implantation mask over a first surface (121) of the SiC semiconductor body (102).

15. The method of any of the three preceding claims, wherein forming the edge termination structure (110) includes
forming a first doped region (1101) of a second conductivity type between the first surface (121) of the SiC semiconductor body (102) and the drift region (108), the first doped region (1101) at least partly surrounding the active region (103) and being spaced apart from the first surface (121);
forming a plurality of second doped regions (1102) of the second conductivity type between the first surface (121) and the first doped region (1101), wherein adjacent second doped regions of the plurality of second doped regions (1102) are separated from one another along the first lateral direction (x1) by a third doped region (1103) of the first conductivity type.
